# EUROPÄISCHE PATENTSCHRIFT

(11) **EP 0 729 224 B1**
(45) Veröffentlichungstag und Bekanntmachung des Hinweises auf die Patenterteilung: **03.11.1999**
(21) Anmeldenummer: 96101461.0
(22) Anmeldetag: 02.02.1996
(51) Int. Cl.: H03F 1/32

(54) **Schaltungsanordnung zur Auswertung von Intermodulationsprodukten**
Circuit for using intermodulation products
Circuit pour utiliser des produits d'intermodulation

(30) Priorität: 22.02.1995 DE 19506051
(43) Veröffentlichungstag der Anmeldung: 28.08.1996
(73) Patentinhaber: MIKOM GmbH, 86675 Buchdorf (DE)
(72) Erfinder: Schmidt, Karl-Heinz, D-86753 Möttingen-Balgheim (DE)
(74) Vertreter: Charrier, Rolf, Dipl.-Ing.

(56) Entgegenhaltungen:
- EP-A- 0 489 276
- EP-A- 0 580 125
- US-A- 3 755 754
- US-A- 5 119 040
- PERSONAL COMMUNICATION - FREEDOM THROUGH WIRELESS TECHNOLOGY, SECAUCUS, NJ., MAY 18 - 20, 1993, Nr. CONF. 43, 18.Mai 1993, INSTITUTE OF ELECTRICAL AND ELECTRONICS ENGINEERS, Seiten 684-687, XP000393275 JOHANSSON M ET AL: "LINEARIZATION OF MULTI-CARRIER POWER AMPLIFIERS"
- ELECTRONICS LETTERS, Bd. 30, Nr. 2, 20.Januar 1994, Seite 114/115 XP000420632 BURGOS-GARCIA M ET AL: "SIMPLE PROCEDURE FOR OPTIMUM LINEARISATION OF AMPLIFIERS IN MULTICARRIER APPLICATIONS"

## Beschreibung

Die Erfindung betrifft eine Schaltungsanordnung zur Auswertung von Intermodulationsprodukten eine nach dem Oberbegriff des Anspruches 1.

Die Charakteristik eines Verstärkers weicht vom Ideal einer linearen Kennlinien ab. Damit werden zusätzlich zum zu verstärkenden Signal auch unerwünschte Produkte erzeugt, die bei Anwesenheit nur eines Nutzsignals als Klirrprodukte und bei Anwesenheit mehrerer Nutzsignale unterschiedlicher Frequenz zusätzlich als Intermodulationsprodukte in Erscheinung treten.

Bei einem Verstärker beispielsweise, der nachrichtentechnische Hochfrequenzsignale verstärken soll, die zum Beispiel in Mobilfunksystemen auftreten, erzeugt daher unter anderem Intermodulationsprodukte ungerader Ordnung, die, wegen des gleichen Frequenzabstands der Kanäle direkt in benachbarte Nutzkanäle fallen. Diese unerwünschten Intermodulationsprodukte sollen daher bezüglich ihrer Amplitude unterhalb eines vorgegebenen Grenzwerts gehalten werden.

Ein Verstärker mit einer Schaltungsanordnung der eingangs genannten Art gemäß dem Oberbegriff des Anspruches 1 ist der WO 92/12571 zu entnehmen. Die Eingangssignale unterschiedlicher Frequenz werden dort einem einstellbaren Dämpfungglied zugeführt und von dort einem Hauptverstärker. Die Ausgangssignale des Hauptverstärkers werden von der Schaltungsanordnung in Form eines Linearitätsmonitors abgegriffen, der eine Stellgröße erzeugt, welche die Dämpfung des Dämpfungsglieds verändert. Hierbei analysiert der Monitor die am Ausgang des Hauptverstärkers auftretenden Intermodulationsprodukte bezüglich ihrer Amplitude. Das Intermodulationsprodukt mit der höchsten Amplitude wird mit einem vorgegebenen Schwellwert verglichen. Wird dieser Schwellwert überschritten, ergibt sich eine Regelabweichung, welche die Stellgröße und damit das Maß der Dämpfung der Eingangssignale bestimmt. Auf diese Weise werden die Intermodulationsprodukte am Ausgang des Hauptverstärkers unterhalb eines vorgegebenen Grenzwerts gehalten. Dabei ist es erforderlich, daß dem Linearitätsmonitor auch die Eingangssignale zugeführt werden, damit dieser die Nutzsignale von den Intermodulationsprodukten unterscheiden kann.

Diese Schaltungsanordnung ist jedoch kompliziert aufgebaut und daher relativ teuer.

Es besteht die Aufgabe, die Schaltungsanordnung der eingangs genannten Art auf kostengünstige Weise zu realisieren.

Gelöst wird diese Aufgabe mit den kennzeichnenden Merkmalen des Anspruches 1. Vorteilhafte Ausgestaltungen sind den Unteransprüchen entnehmbar.

Die Erfindung bewirkt, daß der Verstärker der Schaltungsanordnung Intermodulationsprodukte erzeugt. Durch das nachgeschaltete Filter ist es möglich, bestimmte Intermodulationsprodukte zu filtern und zur Bildung der Stellgröße heranzuziehen. Bevorzugt sind dies solche Intermodulationsprodukte, bei denen dies leicht möglich ist, beispielsweise solche, die mit ihrer Frequenz fern denjenigen der Nutzsignale liegen.

In Anwendung bei einem Verstärker wird die volle Ausnutzung seines Dynamikbereichs bei Anwesenheit nur einer Trägerfrequenz ermöglicht. Die Intermodulationsprodukte im Übertragungsband des Hauptverstärkers werden unter einem vorgegebenen Wert gehalten, wenn mehr als eine Trägerfrequenz vorliegt.

Ausführungsbeispiele werden nachfolgend an Hand der Zeichnungen näher erläutert. Es zeigen:
- **Fig. 1**: eine erste Ausführungsform der Schaltungsanordnung in Anwendung bei einem Verstärker;
- **Fig. 2**: ein Frequenz-Amplituden-Diagramm zur Verdeutlichung der Arbeitsweise der Schaltungsanordnung und des Verstärkers nach Figur 1;
- **Fig. 3**: die Übertragungskennlinie eines Verstärkers mit Ein- und Ausgangssignal >hne Dämpfung;
- **Fig. 4**: die gleiche Übertragungskennlinie und gedämpftem Eingangssignal;
- **Fig. 5**: der Verstärker nach Figur 1 zur Erläuterung von Ausführungsvarianten; und
- **Fig. 6**: ein weiteres Ausführungsbeispiel der Schaltungsanordnung und eines Verstärkers mit Darstellungen von Ausführungsvarianten.

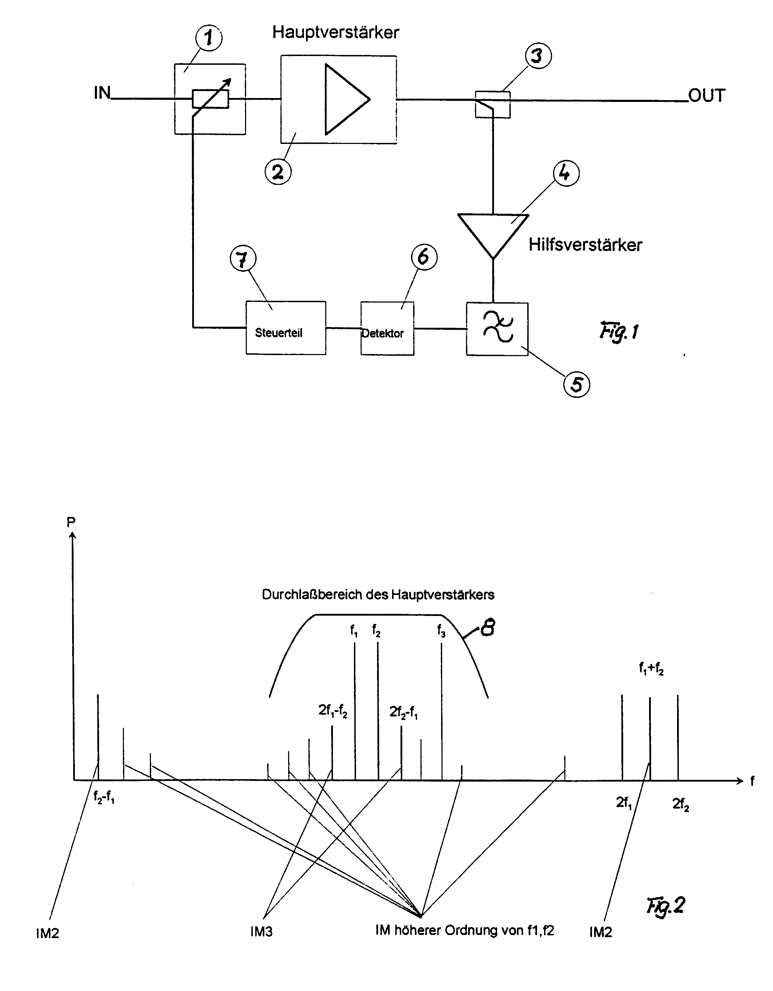

Der Verstärker nach Figur 1 weist ein Dämpfungsglied 1 auf, dem die Eingangssignale IN zugeführt werden. Der Ausgang des Dämpfungsglieds 1 ist mit dem Eingang eines Hauptverstärkers 2 verbunden, an dessen Ausgang die Ausgangssignale OUT auftreten. Der Ausgang des Hauptverstärkers 2 ist über ein Koppelglied 3 mit dem Eingang eines Verstärkers gemäß der Erfindung, nachfolgend Hilfsverstärker 4 genannt, verbunden. Der Ausgang des Hilfsverstärkers 4 ist verbunden mit einem Tiefpaßfilter 5, dessen Ausgang mit einem Detektor 6, z.B. in Form eines Gleichrichters, verbunden ist. An diesen ist ein Steuerteil 7, z.B. ein Regelverstärker, angeschlossen, dessen Ausgang das Dämpfungsglied 1 steuert.

In Figur 2 ist der Durchlaßbereich 8 des Hauptverstärkers 2 dargestellt. Im nachfolgenden Fall sei vorausgesetzt, daß über das Dämpfungsglied 1 dem Hauptverstärker zwei Nutzsignale mit der Frequenz f₁ und f₂ zugeführt werden. Hierbei kann beispielsweise f₁ = 935 MHz und f₂ = 960 MHz betragen. Die verstärkten Nutzsignale mit den Frequenzen f₁ und f₂ treten auch am Ausgang des Hauptverstärkers 2 auf. Neben diesen Nutzsignalen treten am Ausgang des Hauptverstärkers jedoch auch Intermodulationsprodukte, z.B. solche dritter Ordnung IM3 mit den Frequenzen 2f₁ - f₂ und 2f₂ - f₁ auf. Diese Intermodulationsprodukte IM3 fallen in benachbarte Nutzkanäle im Durchlaßbereich 8 und sind daher unerwünscht. Die Amplitude dieser Intermodulationsprodukte darf daher eine vorgegebene Amplitude nicht übersteigen.

Über das Koppelglied 3 werden die vorgenannten Signale dem Eingang des Hilfsverstärkers 4 zugeführt. Dieser Hilfsverstärker 4 weist einen wesentlichen breiteren Durchlaßbereich als der Hauptverstärker 2 auf. Die von ihm verstärkten Nutzsignale mit den Frequenzen f₁ und f₂ bewirken in diesem Hilfsverstärker 4 neben Intermodulationsprodukten dritter Ordnung IM3 zum Beispiel auch Intermodulationsprodukte gerader Ordnung, z.B. zweiter Ordnung IM2 mit den Frequenzen f₂ - f₁ und f₁ + f₂. Im vorgenannten Beispiel weisen die Intermodulationsprodukte zweiter Ordnung IM2 eine Frequenz von 25 MHz und von 1895 MHz auf. Das Tiefpaßfilter 5 ist so ausgelegt, daß es Intermodulationsprodukte im Frequenzbereich von f₂ - f₁ durchläßt, in anderen Frequenzbereichen jedoch sperrt. Auf diese Weise gelangt das Intermodulationsprodukt mit der Frequenz f₂ - f₁ zum Detektor 6 in Form eines Gleichrichters und wird dort gleichgerichtet. Das gleichgerichtete Signal wird im Steuerteil 7 verstärkt und wird als Stellgröße dem Dämpfungsglied 1 zugeführt, womit in Abhängigkeit dieser Stellgröße die Dämpfung der Nutzsignale mit den Frequenzen f₁ und f₂ verändert wird. Je höher die Amplitude des Intermodulationsprodukts zweiter Ordnung IM2 ist, umso stärker werden die dem Hauptverstärker 2 zugeführten Nutzsignale gedämpft. Die Nutzsignale, die dem Hauptverstärker 2 und verstärkt dem Hilfsverstärker 4 zugeführt werden, werden so weit gedämpft, daß die am Ausgang des Hilfsverstärkers auftretenden Intermodulationsprodukte zweiter Ordnung IM2 abgesenkt werden. Damit werden dann die vom Hauptverstärker 2 erzeugten Intermodulationsprodukte dritter Ordnung IM3 unterhalb eines vorgegebenen Amplitudenwerts gehalten.

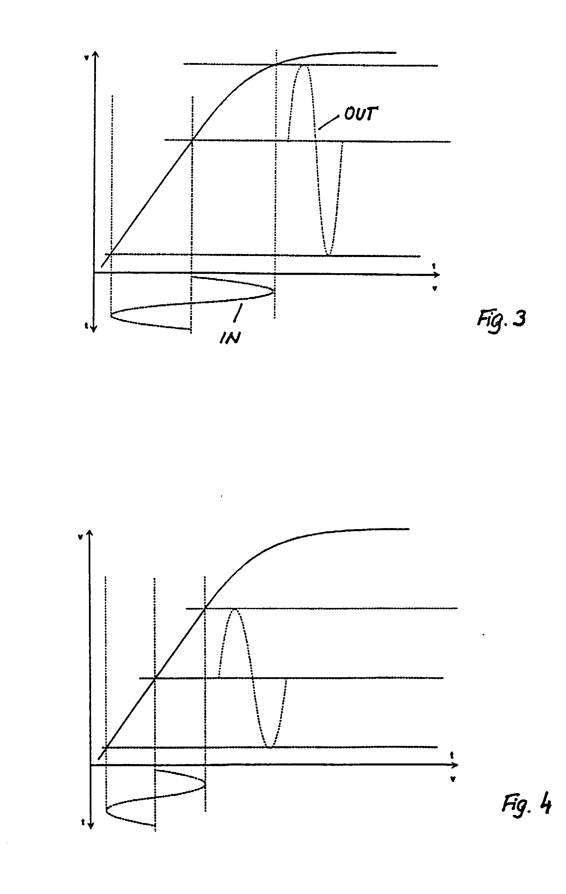

In Figur 3 ist die Übertragungskennlinie des Hauptverstärkers 2 dargestellt, zusammen mit dem Eingangssignal IN und dem Ausgangssignal OUT. Der Verstärker ist bis in den nichtlinearen Teil der Kennlinie ausgesteuert, was zum Auftreten der Intermodulationsprodukte führt. Bei gedämpftem Eingangssignal nach Figur 4 wird dagegen im nahezu linearen Teil der Kennlinie gearbeitet mit dem Ergebnis weitaus geringerer Intermodulationsprodukte.

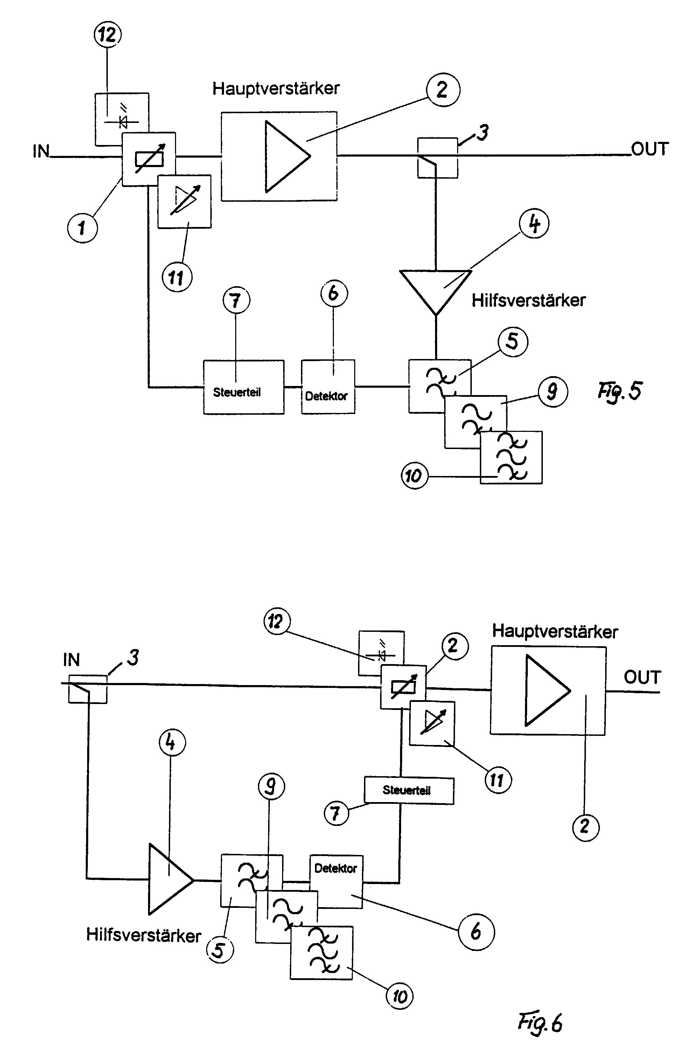

Wird anstelle eines Tiefpaßfilters 5 ein Hochpaßfilter 9 oder ein Bandpaßfilter 10 verwendet, dessen Durchlaßbereich beim Intermodulationsprodukt IM2 mit der Frequenz f₁ + f₂ liegt, dann wird die Stellgröße von diesem Intermodulationsprodukt abgeleitet. Diese Variante ist in Figur 5 dargestellt.

Die vom Steuerteil erzeugte Stellgröße muß nicht notwendigerweise die Dämpfung eines Dämpfungsglieds 1 verändern. Es ist auch möglich, daß die Stellgröße den Verstärkungsgrad eines Vorverstärkers oder den Verstärkungsgrad des Hauptverstärkers 2 oder einer Stufe des Hauptverstärkers verändert. Dies ist in Figur 5 durch den Block 11 dargestellt. Anstelle eines geschlossenen Regelkreises wie zuvor beschrieben, kann die Stellgroße auch einen Alarmmelder 12, beispielsweise in Form einer Leuchtdiode ansteuern, womit dann gegebenenfalls die Änderung der Dämpfung bzw. die Änderung des Verstärkungsgrads manuell veränderbar ist.

Die Nutzsignale mit den Frequenzen f₁ und f₂ müssen nicht notwendigerweise dem Hilfsverstärker 4 vom Ausgang des Hauptverstärkers 2 zugeführt werden. Die Nutzsignale IN, die dem Hilfsverstärker 4 zugeführt werden, können vom Verstärkereingang dem Hilfsverstärker 4 über das Koppelglied 3 zugeführt werden. Dieser Hilfsverstärker 4 weist den gleichen Durchlaßbereich auf, wie im Zusammenhang mit Figur 1 erwähnt. An diesen Hilfsverstärker schließt sich dann ein Tiefpaßfilter 5 oder ein Hochpaßfilter 9 bzw. ein Bandpaßfilter 10 an, dessen Ausgang mit dem Detektor 6 verbunden ist, der seinerseits an das Steuerteil 7 angeschlossen ist. Die vom Steuerteil 7 erzeugte Stellgröße wirkt wiederum auf ein Stellglied, das die Dämpfung oder den Verstärkungsgrad wie vorbeschrieben verändert oder steuert einen Alarmmelder 12 an.

Handelt es sich bei dem Hauptverstärker 2 um einen mehrstufigen Verstärker, so kann das dem Hilfsverstärker 4 zugeführte Signal an jeder beliebigen Stufe des Hauptverstärkers 2 abgegriffen werden.

Gemäß der vorstehenden Beschreibung steuert die Stellgröße ein Dämpfungsglied 1 an oder verändert den Verstärkungsgrad eines vor dem Hauptverstärker 2 angeschlossenen Vorverstärkers oder den Verstärkungsgrad des Hauptverstärkers 2 oder einer seiner Stufen selbst. Es ist jedoch auch möglich, daß die Stellgröße sowohl eine Dämpfung als auch eine Veränderung eines der vorgenannten Verstärkungsgrade bewirkt. Daneben ist es möglich, zusätzlich einen Alarmmelder 12 anzusteuert.

Eine weitere Variante kann darin bestehen, daß dem Hilfsverstärker 4 sowohl ein Tiefpaßfilter 5 als auch ein Hochpaßfilter 9 nachgeschaltet ist und somit beide Intermodulationsprodukte IM2 zur Bildung der Stellgröße verarbeitet werden.

## Patentansprüche

1. Schaltungsanordnung, bestehend aus einem Hauptverstärker, einem im Signalpfad des Hauptverstärkers angeordneten, einstellbaren Dämpfungsglied, einem Steuerteil, das eine die Dämpfung des Dämpfungsglieds bestimmende Stellgröße erzeugt und einem dem Stellglied vorgeschalteten Filter, dem Hauptverstärker Eingangssignale unterschiedlicher Frequenz zugeführt werden, der Hauptverstärker neben den verstärkten Eingangssignalen unerwünschte Intermodulationsprodukte erzeugt, das Filter Intermodulationsprodukte durchläßt und die vom Filter durchgelassenen Intermodulationsprodukte die Stellgröße bestimmen, bei der durch Dämpfung der Eingangssignale die Amplitude der vom Hauptverstärker erzeugten Intermodulationsprodukte unter einem Grenzwert gehalten werden, dadurch **gekennzeichnet,** daß dem Filter (5,9,10) ein Hilfsstärker (4) vorgeschaltet ist, dem ebenfalls die Eingangssignale zugeführt werden und der Intermodulationsprodukte erzeugt, die außerhalb des Durchlaßbereichs (8) des Hauptverstärkers (2) liegen und mindestens eines dieser Intermodulationsprodukte die Stellgröße bestimmt.

2. Schaltungsanordnung nach Anspruch 1, dadurch **gekennzeichnet**, daß das vom Hilfverstärker (4) erzeugte und vom Filter (5,9,10) durchgelassene Intermodulationsprodukt ein solches zweiter Ordnung (IM2) ist.

3. Schaltungsanordnung nach Anspruch 2, dadurch **gekennzeichnet**, daß das Filter ein Tiefpaßfilter (5) ist, dessen Durchlaßbereich bei der Differenzfrequenz der Eingangssignale (f₁,f₂) liegt.

4. Schaltungsanordnung nach Anspruch 2, dadurch **gekennzeichnet,** daß das Filter ein Hochpaß- oder Bandpaßfilter (9,10) ist, dessen Durchlaßbereich bei der Summenfrequenz der Eingangssignale (f₁,f₂) liegt.

5. Schaltungsanordnung nach einem der Ansprüche 1 bis 4, dadurch **gekennzeichnet,** daß zwischen dem Filter (5,9,10) und dem Steuerteil (7) ein Detektor (6) geschaltet ist.

6. Schaltungsanordnung nach Anspruch 5, dadurch **gekennzeichnet,** daß der Detektor (6) ein Gleichrichter und das Steuerteil (7) ein weiterer Verstärker ist.

7. Schaltungsanordnung nach einem der Ansprüche 1 bis 6, dadurch **gekennzeichnet,** daß die Stellgröße auf ein Stellglied wirkt.

8. Schaltungsanordnung nach einem der Ansprüche 1 bis 7, dadurch **gekennzeichnet,** daß die Stellgröße auf einen Alarmmelder (12) wirkt, wenn die Stellgröße einen vorgegebenen Wert überschreitet.

9. Schaltungsanordnung nach Anspruch 7, dadurch **gekennzeichnet,** daß die Stellgröße ein vor dem Hauptverstärker (2) geschaltetes, die Eingangssignale (IN) dämpfendes Dämpfungsglied (1) steuert.

10. Schaltungsanordnung nach Anspruch 7, dadurch **gekennzeichnet,** daß die Stellgröße den Verstärkungsgrad mindestens einer zwischen dem Verstärkereingang und -ausgang geschalteten Verstärkerstufe verändert.

11. Schaltungsanordnung nach einem der Ansprüche 1 bis 10, dadurch **gekennzeichnet,** daß der Eingang des Hilfsverstärkers (4) über ein Koppelglied (3) mit dem Ausgang des Hauptverstärkers (2) verbunden ist.

12. Schaltungsanordnung nach einem der Ansprüche 1 bis 10, dadurch **gekennzeichnet,** daß der Eingang des Hilfsverstärkers (4) über ein Koppelglied (3) mit dem Eingang des Hauptverstärkers (2) verbunden ist.

## Claims

1. Circuit arrangement, consisting of a main amplifier, an adjustable attenuator disposed in the signal path of the main amplifier, a control section which produces a correcting variable determining the attenuation of the attenuator, and of a filter connected in series with the attenuator, the main amplifier being fed with input signals of different frequency, the main amplifier producing undesired intermodulation products in addition to the amplified input signals, the filter passing intermodulation products and the intermodulation products passed by the filter determining the correcting variable with which the amplitude of the intermodulation products produced by the main amplifier is kept below a limit value by attenuation of the input signals, characterised in that the filter (5, 9, 10) is connected in series with an auxiliary amplifier (4) which is also fed with the input signals and which produces intermodulation products which lie outside the pass band (8) of the main amplifier (2), and at least one of these intermodulation products determines the correcting variable.

2. Circuit arrangement according to claim 1, characterised in that the intermodulation product produced by the auxiliary amplifier (4) and passed by the filter (5, 9, 10) is an intermodulation product of the second order (IM2).

3. Circuit arrangement according to claim 2, characterised in that the filter is a low pass filter (5) the pass band of which lies at the difference frequency of the input signals (f₁, f₂).

4. Circuit arrangement according to claim 2, characterised in that the filter is a high pass or band pass filter (9, 10) the pass band of which lies at the sum frequency of the input signals (f₁, f₂).

5. Circuit arrangement according to one of claims 1 to 4, characterised in that a detector (6) is connected between the filter (5, 9, 10) and the control section (7).

6. Circuit arrangement according to claim 5, characterised in that the detector (6) is a rectifier and the control section (7) is a further amplifier.

7. Circuit arrangement according to one of claims 1 to 6, characterised in that the correcting variable acts on a final control element.

8. Circuit arrangement according to one of claims 1 to 7, characterised in that the correcting variable acts on an alarm indicator (12) when the correcting variable exceeds a predetermined value.

9. Circuit arrangement according to claim 7, characterised in that the correcting variable controls an attenuator (1) connected in series with the main amplifier (2) and attenuating the input signals (IN).

10. Circuit arrangement according to claim 7, characterised in that the correcting variable alters the gain of at least one amplifier stage connected between the amplifier input and output.

11. Circuit arrangement according to one of claims 1 to 10, characterised in that the input of the auxiliary amplifier (4) is connected to the output of the main amplifier (2) by means of a coupling element (3).

12. Circuit arrangement according to one of claims 1 to 10, characterised in that the input of the auxiliary amplifier (4) is connected to the input of the main amplifier (2) by means of a coupling element (3).

## Revendications

1. Agencement de circuit, constitué d'un amplificateur principal, d'un atténuateur réglable, disposé sur le trajet de signal de l'amplificateur principal, d'une partie de commande, qui produit une grandeur de réglage déterminant l'atténuation de l'atténuateur, et d'un filtre connecté en amont de l'organe de réglage, tandis que des signaux d'entrée de fréquences différentes sont envoyés à l'amplificateur principal, que l'amplificateur principal crée, outre les signaux d'entrée amplifiés, des produits d'intermodulation non souhaités, que le filtre laisse passer des produits d'intermodulation et que les produits d'intermodulation que le filtre a laissés passer détermine la grandeur de réglage, agencement dans lequel, au moyen d'une atténuation des signaux d'entrée, l'amplitude des produits d'intermodulation créés par l'amplificateur principal est maintenue au-dessous d'une valeur limite, caractérisé en ce qu'il est prévu, connecté en amont du filtre (5, 9, 10), un amplificateur auxiliaire (4) auquel les signaux d'entrée sont également envoyés et qui crée des produits d'intermodulation qui sont situés en dehors de la bande passante (8) de l'amplificateur principal (2), tandis qu'au moins un de ces produits d'intermodulation détermine la grandeur de réglage.

2. Agencement de circuit suivant la revendication 1, caractérisé en ce que le produit d'intermodulation qui est créé par l'amplificateur auxiliaire (4) et que le filtre (5, 9, 10) laisse passer est un produit d'intermodulation du second ordre (IM2).

3. Agencement de circuit suivant la revendication 2, caractérisé en ce que le filtre est un filtre passe-bas (5) dont la bande passante est située à l'endroit de la différence de fréquences des signaux d'entrée (f1, f2).

4. Agencement de circuit suivant la revendication 2, caractérisé en ce que le filtre est un filtre passe-haut ou passe-bande (9, 10) dont la bande passante est située à l'endroit de la somme des fréquences des signaux d'entrée (f1, f2).

5. Agencement de circuit suivant l'une des revendications 1 à 4, caractérisé en ce qu'un détecteur (6) est connecté entre le filtre (5, 9, 10) et la partie de commande (7).

6. Agencement de circuit suivant la revendication 5, caractérisé en ce que le détecteur (6) est un redresseur et la partie de commande (7) un autre amplificateur.

7. Agencement de circuit suivant l'une des revendications 1 à 6, caractérisé en ce que la grandeur de réglage agit sur un organe de réglage.

8. Agencement de circuit suivant l'une des revendications 1 à 7, caractérisé en ce que la grandeur de réglage agit sur un avertisseur d'alarme (12) lorsque la grandeur de réglage dépasse une valeur préfixée.

9. Agencement de circuit suivant la revendication 7, caractérisé en ce que la grandeur de réglage commande un atténuateur (1) connecté en amont de l'amplificateur principal (2) et atténuant les signaux d'entrée (IN).

10. Agencement de circuit suivant la revendication 7, caractérisé en ce que la grandeur de réglage modifie le gain d'au moins un étage d'amplificateur connecté entre l'entrée d'amplificateur et la sortie d'amplificateur.

11. Agencement de circuit suivant l'une des revendications 1 à 10, caractérisé en ce que l'entrée de l'amplificateur auxiliaire (4) est reliée par l'intermédiaire d'un élément de couplage (3) à la sortie de l'amplificateur principal (2).

12. Agencement de circuit suivant l'une des revendications 1 à 10, caractérisé en ce que l'entrée de l'amplificateur auxiliaire (4) est reliée par l'intermédiaire d'un élément de couplage (3) à l'entrée de l'amplificateur principal (2).
